# EUROPEAN PATENT APPLICATION

(11) **EP 1 857 407 A2**
(43) Date of publication of application: **21.11.2007**
(21) Application number: 07075352.0
(22) Date of filing: 07.05.2007
(51) Int. Cl.: B81C 3/00

(54) **Method of aligning mask layers to buried features**

(30) Priority: 16.05.2006 US 434643
(71) Applicant: Delphi Technologies, Inc., Troy, Michigan 48007 (US)
(72) Inventor: Freeman, John E., Kempton, IN 46049 (US); Staller, Steven E., Russiaville, IN 46979 (US); Chase, Troy A., Kokomo, IN 46902 (US)
(74) Representative: Denton, Michael John

(57) **Abstract**

A method for fabricating microchip devices is provided. The method includes the steps of providing a first planar substrate (120), locating at least one first alignment feature (128) in the surface (122) of the first planar substrate (120), and bonding a second substrate (140) to the surface (122) of the first planar substrate (120). The method further includes the step of aligning subsequent process operations performed on at least one of the first (120) and second (140) substrates to visible alignment features of the first substrate (120), wherein the visible alignment features are at least one of the first alignment feature (128) and a visible feature that corresponds to the location of the first alignment feature (128).

## Description

### Technical Field

The present invention relates generally to microchip device fabrication, and more specifically to the fabrication of microchip devices in a process that requires subsequent mask layers and features to be aligned with an earlier-formed feature of the microchip device.

### Background of the Invention

The fabrication of microchip devices, including integrated circuits and Micro-Electro-Mechanical-Systems (MEMS), involves careful alignment of multiple operations performed on a wafer or substrate. For example, between various layering, doping and heat treating operations, patterns, generally in the form of image mask layers, are carefully aligned to the earlier-formed substrate features in order to provide the desired relative location of the features defined by the mask layer.

Aligning layers and/or equipment is usually performed using alignment features that have been formed on the process side of the wafer or substrate. For example, markings made in the surface of a wafer or substrate using a laser can provide a registration reference, and may also provide substrate identification information. Optical or non-optical alignment equipment, or other process equipment, is generally utilized to register the alignment features and/or markings, and properly position subsequent processing operations and structures relative to the alignment features. Optical aligners may utilize visible or infrared imaging to register the alignment feature, while non-optical aligners may utilize x-ray or other energy beam imaging to register the alignment feature.

The fabrication of some microchip devices currently requires that mask levels or other elements or equipment be aligned relative to a previously defined alignment feature that has been buried or hidden beneath a layer or layers by intervening process steps. One conventional technique for providing the required alignment to buried or hidden alignment features is to employ specialized, often expensive, wafer fabrication equipment that uses infrared or non-optical sources capable of penetrating the silicon and revealing the earlier-formed features that have been buried or hidden.

What is needed is a microchip device processing method for providing unburied alignment features that can be conveniently formed, and that can be used to align process operations, layers, and features without requiring equipment capable of locating buried or hidden alignment features.

### Summary of the Invention

In accordance with one aspect of the present invention, a method for processing a microchip device is provided. The method includes the steps of forming at least one alignment feature in at least one peripheral region of a process side of a first substrate, overlaying a second substrate on the process side of the first substrate such that the at least one alignment feature remains exposed for subsequent process operations, and bonding the second substrate to the process side of the first substrate. The method may also include the step of removing at least one segment of the outer periphery of the second substrate corresponding to the at least one peripheral region of the first segment. The method further includes the steps of aligning a subsequent process operation on the second substrate based on the at least one alignment feature, and forming recesses in a device layer located on the process side of the first substrate, wherein the recesses are used to allow deflection of a mechanical feature of the second substrate towards the first substrate.

In accordance with another aspect of the present invention, a method for processing a microchip device is provided. The method includes the steps of forming at least one alignment feature on a process side of a first substrate that has a device layer on the process side located in reference to the at least one alignment feature. The method also includes the step of bonding a second substrate to the process side of the first substrate. The method further includes the steps of removing a portion of the second substrate overlaying the at least one alignment feature, and registering the alignment feature to align a subsequent process operation on the second substrate with the device layer of the first substrate based on the at least one alignment feature. The exemplary method may also include the step of forming recesses in the device layer of the first substrate, wherein the recesses are used to allow deflection of a mechanical feature of the second substrate toward the first substrate.

In accordance with still another aspect of the present invention, a method for processing a microchip device is provided. The method includes the steps of forming at least one recess along at least one segment of the periphery of the process side of a first substrate, and locating at least one alignment feature in the at least one recess. The method further includes the steps of bonding a second substrate to the process side of the first substrate, removing a portion of the second substrate and bonding material overlaying the at least one alignment feature, and registering the at least one alignment feature to align a subsequent process operation on the second substrate with the device layer of the first substrate. The method may also include the step of forming recesses in the device layer of the first substrate, wherein the recesses are used to allow deflection of a mechanical feature of the second substrate toward the first substrate.

In accordance with still another aspect of the present invention, a method for processing a microchip device is provided. The method includes the steps of providing a first silicon wafer having a pattern on its upper surface, including at least one alignment feature that is a cavity or depression in the upper surface, depositing etch stop and bond layers on the upper surface of the first silicon wafer, and forming a cavity in the upper surface of the first silicon wafer that is positioned at a specific location relative to the alignment feature. The method also includes the steps of inverting the first silicon wafer and bonding its upper surface to the surface of a second wafer, removing exposed layers of the first silicon wafer, and locating additional circuit elements and/or layers in the exposed surface of the first wafer relative to the alignment features of the first silicon wafer.

These and other features, advantages and objects of the present invention will be further understood and appreciated by those skilled in the art by reference to the following specification, claims and appended drawings.

### Brief Description of the Drawings

The present invention will now be described, by way of example, with reference to the accompanying drawings, in which:
FIGS. 1A-1B are perspective views of a substrate structure illustrating a first exemplary process for fabricating microchip devices;
FIGS. 2A-2G are cross-sectional views taken through a structure that illustrate more fully the first exemplary process of FIGS. 1A-1B;
FIGS. 3A-3H are cross-sectional views taken through a structure that illustrate a second exemplary process for fabricating microchip devices;
FIGS. 4A-4G are cross-sectional views taken through a structure that illustrate a third exemplary process for fabricating microchip devices; and
FIGS. 5A-5H are cross-sectional views taken through a structure that illustrate a fourth exemplary process for fabricating microchip devices.

### Description of the Preferred Embodiments

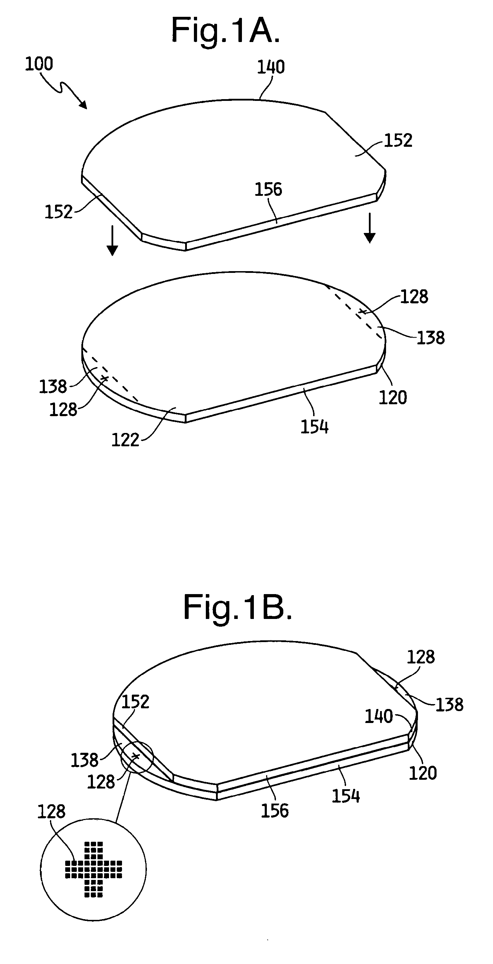

Referring to FIGS. 1A and 1B, a first exemplary process 100 for fabricating microchip devices is shown. The process 100 includes selectively locating alignment features 128 on a first substrate 120 and selectively sizing and shaping a second substrate 140 so that after the substrates 120 and 140 are bonded together, as shown in FIG. 1B, the alignment features 128 are not buried by the second substrate 140, but remain accessible from the process side 122.

In the exemplary embodiment of the invention shown in FIGS. 1A and 1B, the alignment features 128 are located in approximately oppositely located peripheral regions 138 of the first substrate 120. The peripheral profile of the second substrate 140 includes the minor flats 152 located and shaped so that the second substrate 140 is sized and shaped to coincide with the peripheral regions 138. By locating and shaping the minor flats 152 to coincide with the peripheral regions 138, the alignment features 128 remain exposed after the overlaying of the second substrate 140 onto the first substrate 120 as shown in FIG. 1B. Thus the alignment features 128 may be used for aligning subsequent process operations.

The first substrate 120 and the second substrate 140 may also include major flats 154 and 156, respectively. One minor flat and one major flat are generally utilized on semiconductor circuit wafers, and aid identification of the type of doping or other characteristics of the wafer. Adding an additional minor flat or relocating the minor flats to provide the desire exposure of the otherwise underlying alignment features 128 provides a cost effective solution, as modification of standard silicon or other semiconductor wafer stock can be achieved without using specialized equipment or operations.

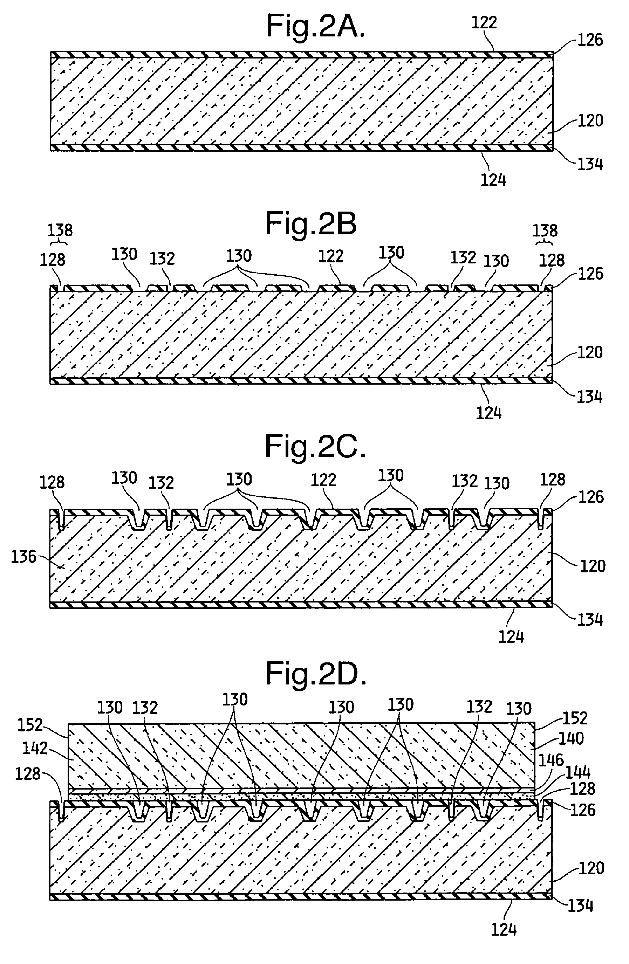

FIGS. 2A-2G illustrate the first exemplary process 100 in further detail. The process 100 includes preliminary steps for the fabrication of microchip devices on a wafer, including, for example, microchip devices having a movable mechanical structure. Such microchip devices may comprise, for example, pressure sensors and/or accelerometers.

FIG. 2A illustrates a first substrate 120, for example, a silicon or other semiconductor wafer, which includes a process side 122 and a back side 124. Dielectric layers 126 and 134, for example, 12 kilo-angstroms (kA) thick layers of silicon oxide, are grown on the process side 122 and the back side 124, respectively, of the first substrate 120.

FIG. 2B illustrates the first substrate 120 after a masking operation, for example, photolithography, has been used to define features to be formed in the dielectric layer 126, and after an etching operation has been performed to form the features in the dielectric layer. As shown, these features include alignment features 128, recesses 130, and other features or devices. The alignment features 128 are used for aligning subsequent operations relative to recesses 130 and/or other features of the first substrate 120. The alignment features 128 may be located in approximately oppositely located peripheral regions 138 of the first substrate 120. Recesses 130 provide a cavity into which later defined mechanical structures, such as, for example, micro- or nano-structures in a pressure sensor or accelerometer, can deflect. Dielectric layer 126 is also referred to herein as a device layer, and may alternatively comprise materials commonly used in semiconductor or microchip fabrication, such as, for example, semiconductors, conductors, or a combination of materials. A number of microchip devices can be formed from the exemplary embodiment of FIGS. 2A-2G. For example, each recess 130 may be associated with a separate, individual microchip device.

To obtain the structure as shown in FIG. 2B, a masking operation is performed on dielectric layer 126 to define features to be formed in the dielectric layer 126. Subsequent to the masking operation, a back side spin process may be used to apply a protective resist layer (not shown) on the back side 124. Alternatively, the back side spin process may be omitted.
The dielectric layer 126 is then etched to remove portions of the dielectric layer 126 to form the alignment features 128 and the recesses 130. The features 132 may also be formed in dielectric layer 126, and may include alignment and/or wafer identifying features. Alternatively, the features 132 may be preexisting features defined during an earlier wafer manufacturing process. After the dielectric layer 126 is etched, the back side 124 protective resist layer, if present, is stripped. In an alternative embodiment, alignment features 128, recesses 130, and features 132 may be formed in a different manner, such as, for example, by a laser.

FIG. 2C illustrates the first substrate 120 after the alignment features 128, features 132, and recesses 130 have been extended into the silicon 136 or other material of the substrate 120 by an etching process using for example, a potassium hydroxide etching solution. After etching, the dielectric layers 126 and 134 may be stripped and regrown to form, for example, dielectric layers 126 and 134 of 18 kA bond silicon oxide.

FIG. 2D illustrates that a second substrate 140 is bonded to the process side 122 of the first substrate 120. The second substrate 140 may be silicon or another semiconductor or substrate material. Second substrate 140 may include an etch stop layer 146 comprising, for example, a highly doped P layer, and an outer bond layer 144 comprising, for example, an epitaxial silicon layer or a single crystal layer. As discussed above and illustrated in FIGS. 1A and 1B, the second substrate 140 includes minor flats 152 located and shaped so that alignment features 128 remain exposed after the overlaying of the second substrate 140 onto the first substrate. Because the alignment features 128 remain exposed, they may be used for aligning subsequent process operations relative to the features of the first substrate 120.

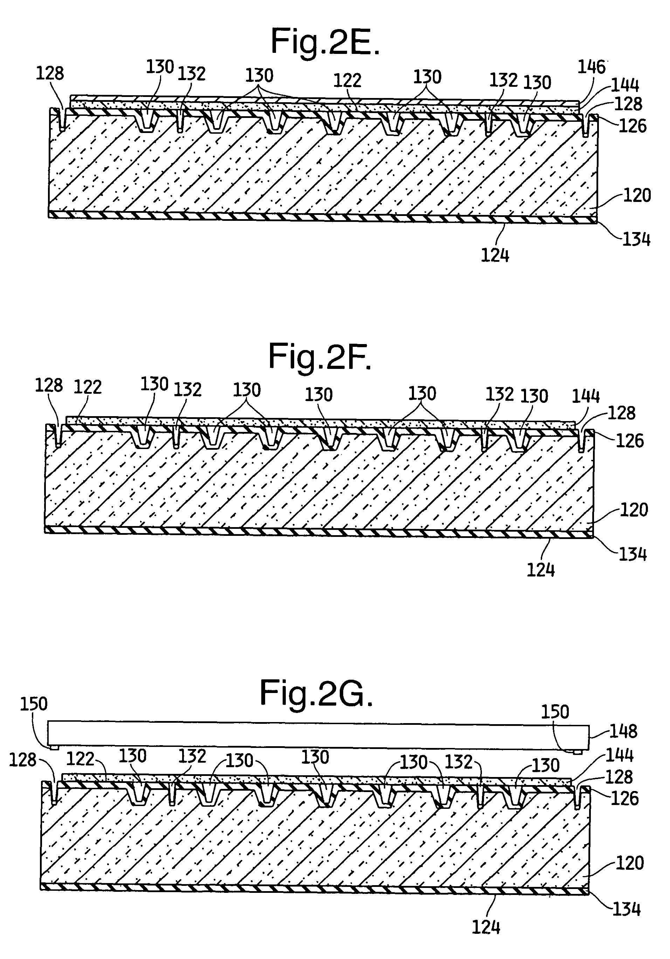

FIG. 2E illustrates the first substrate 120 and the second substrate 140 after the second substrate 140 has been etched back to the etch stop layer 146. Specifically, the silicon 142 or other material of the second substrate 140 may be etched back with a potassium hydroxide or other etching solution. Alternatively, substrate 140 may be ground back to bond layer 144 using, for example, a mechanical grinding process.

FIG. 2F illustrates the first substrate 120 after the etch stop layer 146 (if present) has been etched away or ground back, leaving only the bond layer 144 of the second substrate 140 as the outermost layer of the process side 122 of the first substrate 120. The alignment features 128 located on the process side 122 of the first substrate 120 remain exposed for use in aligning subsequent process steps.

FIG. 2G illustrates a mask 148 with alignment features 150 being aligned relative to the alignment features 128 of the first substrate 120 in order to pattern the bond layer 144 on the process side 122 of the first substrate 120. Specifically, aligning the alignment features 150 of the mask 148 with the alignment features 128 of the first substrate 120 ensures that the pattern applied to the bond layer 144 is properly aligned with alignment features 128, recesses 130, and any other earlier defined features of the first substrate 120 that are buried under the bond layer 144.

Process steps subsequent to those illustrated in FIGS. 2A-2G may then be completed based on alignment to features that are patterned onto the bond layer 144 by the mask 148 in order to complete fabrication of the microchip devices, including semiconductor circuits or micro-machined devices on the process side 122. Advantageously, by eliminating the back to front side processes steps discussed in the background, the microchip device fabrication process 100 illustrated in FIGS. 2A-2G provides for the alignment of subsequent features to earlier-formed buried layers and/or features with submicron accuracy. Additionally, single-side polished wafers may be used for substrates 120 and 140, masking and etching process steps are eliminated, and no manual alignments are required. Finally, because substrates 120 and 140 do not have to be turned over for any process operations, scrap and defects associated with processing the backside 124 of the first substrate 120 are eliminated.

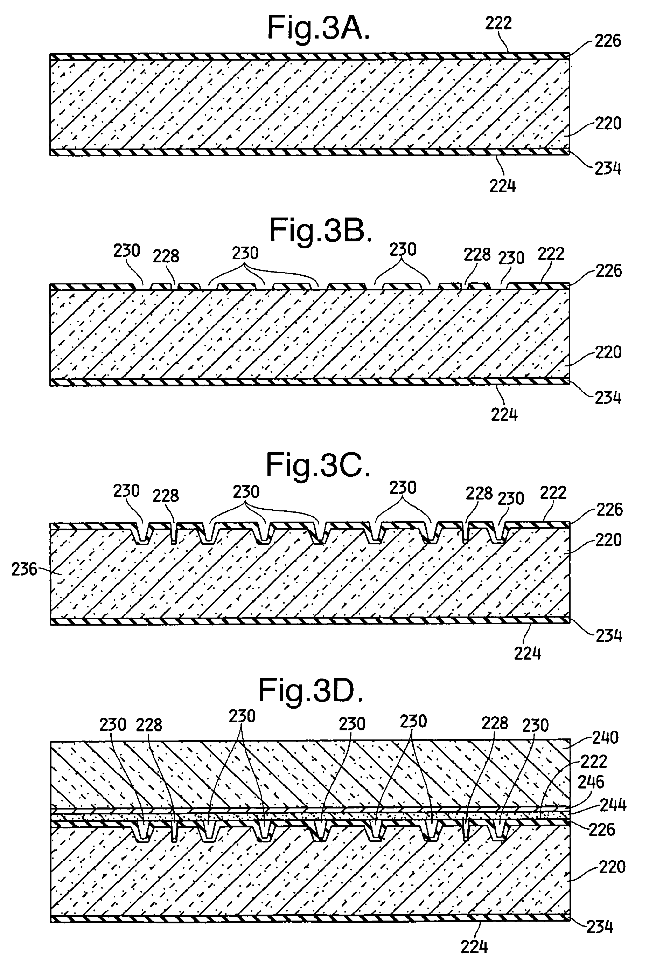

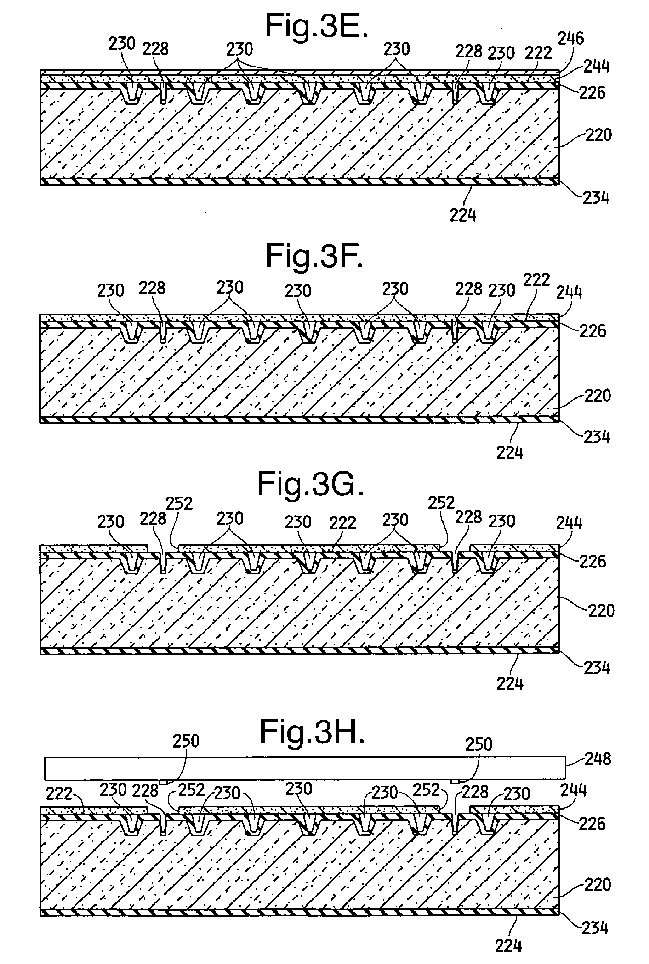

FIGS. 3A-3H illustrate a second exemplary process for fabricating microchip devices. The process 200 includes several of the preliminary steps for the fabrication of microchip devices on a wafer, including, for example, microchip devices having a movable mechanical structure. Such microchip devices may comprise, for example, pressure sensors and/or accelerometers. The process 200 illustrated in FIGS. 3A-3F and 3H is substantially the same as the process 100 illustrated in FIGS. 2A-2G, except for the differences as noted below. In addition, the process 200 includes the additional steps illustrated in FIG. 3G and discussed below.

FIG. 3A illustrates a first substrate 220, for example, a silicon or other semiconductor wafer, which includes a process side 222 and a back side 224. Dielectric layers 226 and 234, for example, a 12 kilo-angstroms (kA) thick layers of silicon oxide, are grown on the process side 222 and the back side 224, respectively, of the first substrate 220.

FIG. 3B illustrates the first substrate 220 after a masking operation, for example, photolithography, has been used to pattern features to be formed in the dielectric layer 226, and after an etching operation has been performed to form the features into the dielectric layer. As shown, the features include alignment features 228, recesses 230, and may also include other features or devices. The alignment features 228 are used for aligning subsequent operations relative to recesses 230 and/or other features of the first substrate 220. Unlike the alignment features 128 of the process 100, the alignment features 228 may be located in the interior regions, rather than the peripheral regions, of the first substrate 220.

To obtain the structure as shown in FIG. 3B, a masking operation is performed on dielectric layer 226 to define features to be formed in the dielectric layer 226. Subsequent to the masking operation, a back side spin process is used to apply a protective resist layer (not shown) on the back side 224. Alternatively, the back side spin process may be omitted. The dielectric layer 226 is then etched to remove the portions of the dielectric layer 226 to form the alignment features 228 and the recesses 230. The alignment features 228 may also include wafer identifying features. After the dielectric layer 226 is etched, the back side 224 protective resist layer, if present, is stripped.

FIG. 3C illustrates the first substrate 220 after the alignment features 228 and the recesses 230 have been extended into the silicon 236 or other material of the first substrate 220 by an etching process, using, for example, a potassium hydroxide etching solution. After etching, the dielectric layers 226 and 234 are stripped and regrown to form, for example, dielectric layers 226 and 234 of 18 kA bond silicon oxide.

FIG. 3D illustrates that a second substrate 240 is bonded to the process side 222 of the first substrate 220. The second substrate 240 may include an etch stop layer 246 comprising, for example, a highly doped P layer, and an outer bond layer 244 comprising, for example, an epitaxial silicon layer or a single crystal layer. Note that unlike the process 100, the alignment features 228 located on the process side 222 of the first substrate 220 are buried or hidden by the overlying second substrate 240, and remain buried until the process operations illustrated in FIG. 3G.

FIG. 3E illustrates the first substrate 220 and the second substrate 240 after the second substrate 240 has been etched back to the etch stop layer 246. Specifically, the silicon 242 or other material of the second substrate 240 may be etched back with a potassium hydroxide or other etching solution. Alternatively, substrate 240 may be ground back to bond layer 244 using, for example, a mechanical grinding process.

FIG. 3F illustrates the first substrate 220 after the etch stop layer 246 (if present) has been etched away or ground back, leaving only the bond layer 244 of the second substrate 240 as the outermost layer of the process side 222 of the first substrate 220.

FIG. 3G illustrates the first substrate 220 after bond layer 244 has been patterned and etched to capture and expose the alignment features 228. Specifically, the bond layer 244 is patterned with a mask (not shown) for defining a capture window 252. The mask may be manually aligned to the first substrate 220. The capture window 252 is sized large enough to accommodate positioning errors associated with manual alignment of the mask without reference to the alignment features 228, while ensuring that the capture windows 252 overlay the alignment features 228, as illustrated in FIG. 3G. After the bond layer 244 is patterned, the capture windows 252 are etched into the bond layer 244 using, for example, a dry etching process. As FIG. 3G illustrates, alignment features 228 are exposed as a result of the etching process applied to bond layer 244.

FIG. 3H illustrates a mask 248 with alignment features 250 being aligned relative to the now-exposed alignment features 228 of the first substrate 220 in order to pattern the bond layer 244 on the process side 222 of the first substrate 220. Specifically, aligning the alignment features 250 of the mask 248 with the alignment features 228 of the first substrate 220 ensures that the pattern applied to the bond layer 240 is properly aligned with the recesses 230, and any other earlier defined features of the first substrate 220 that are buried or hidden under the bond layer 244.

Process steps subsequent to those illustrated in FIGS. 3A-3H may then be completed based on alignment to features that are patterned onto the bond layer 244 by the mask 248 in order to complete fabrication of the microchip devices, including semiconductor circuits or micro-machined devices on the process side 222. Advantageously, the process 200 requires no upside down processing of the substrate 200 for back side alignment feature operations, only one manual projection alignment, and at most only one back side spin operation. In addition, single side polished wafers can be utilized for the substrates 220 and 240.

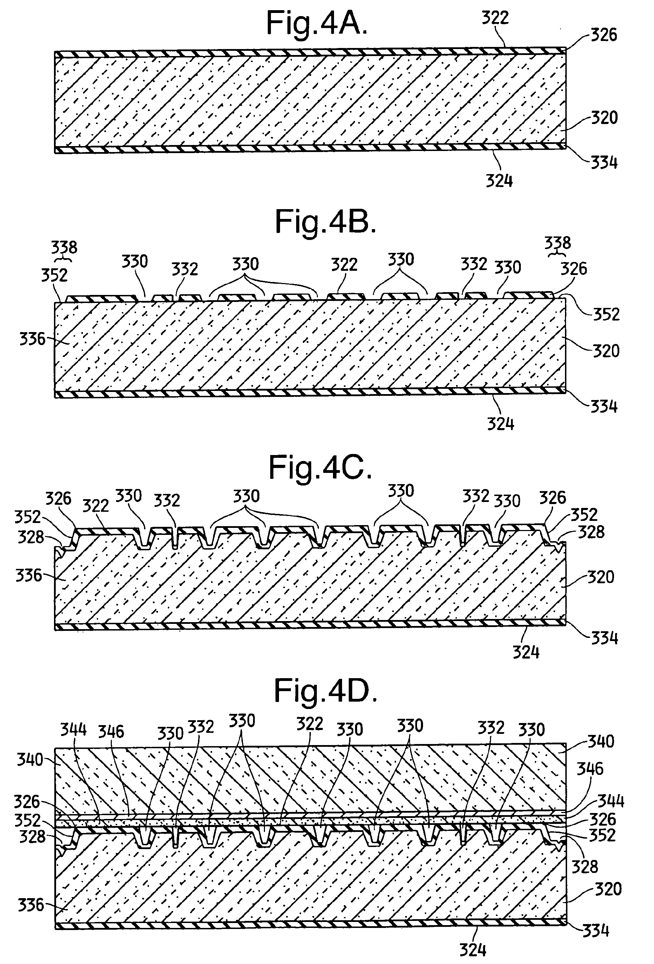

FIGS. 4A-4G illustrate a third exemplary process for fabricating microchip devices. The process 300 includes several preliminary steps for the fabrication of microchip devices on a wafer, including, for example, microchip devices having a movable mechanical structure. Such microchip devices may comprise, for example, pressure sensors and/or accelerometers.

FIG. 4A illustrates a first substrate 320, for example, a silicon or other semiconductor wafer, which includes a process side 322 and a back side 324. Dielectric layers 326 and 334, for example, 12 kilo-angstroms (kA) thick layers of silicon oxide, are grown on the process side 322 and the back side 324, respectively, of the first substrate 320.

FIG. 4B illustrates the first substrate 320 after a masking operation, for example, photolithography, has been used to define features to be formed in the dielectric layer 326, and after an etching operation has been performed to form the features in the dielectric layer. As shown, these features include alignment recesses 352, recesses 330, and other features or devices. The alignment recesses 352 may be located in oppositely located peripheral regions 338 of the first substrate 320. The alignment recesses 352 define an area in which alignment features 328 will be subsequently formed as illustrated in FIG. 4C. Features 332 may also be formed in the dielectric layer 326, and may include alignment and/or wafer identifying features. Alternatively, the features 332 may be preexisting features defined during the prior wafer manufacturing process.

To obtain the structure as shown in FIG. 4B, a masking operation is performed on dielectric layer 326 to define features to be formed in the dielectric layer 226. Subsequent to the masking operation, a back side spin process may be used to apply a protective resist layer (not shown) on the back side 324. Alternatively, the back side spin process may be omitted. The dielectric layer 326 is then etched to remove the portions of the dielectric layer 326 to form the alignment recesses 352, the features 332, and the recesses 330. After the dielectric layer 326 is etched, the back side 324 protective resist layer, if present, is stripped.

FIG. 4C illustrates the first substrate 320 after alignment recesses 352, features 332, and recesses 330 have been extended into the silicon 336 or other material of the first substrate 320 by an etching process using, for example, a potassium hydroxide etching solution. After etching, the dielectric layers 326 and 334 are stripped and regrown to form, for example, dielectric layers 326 and 334 of 18 kA bond silicon oxide. The alignment features 328 are then patterned at the recesses 352 by a masking operation, for example, photolithography, and etched into the layer 326. The alignment features 328 may also include wafer identifying features. The alignment features 328 are used for aligning subsequent operations and features relative to the recesses 330 and/or other features of the first substrate 320.

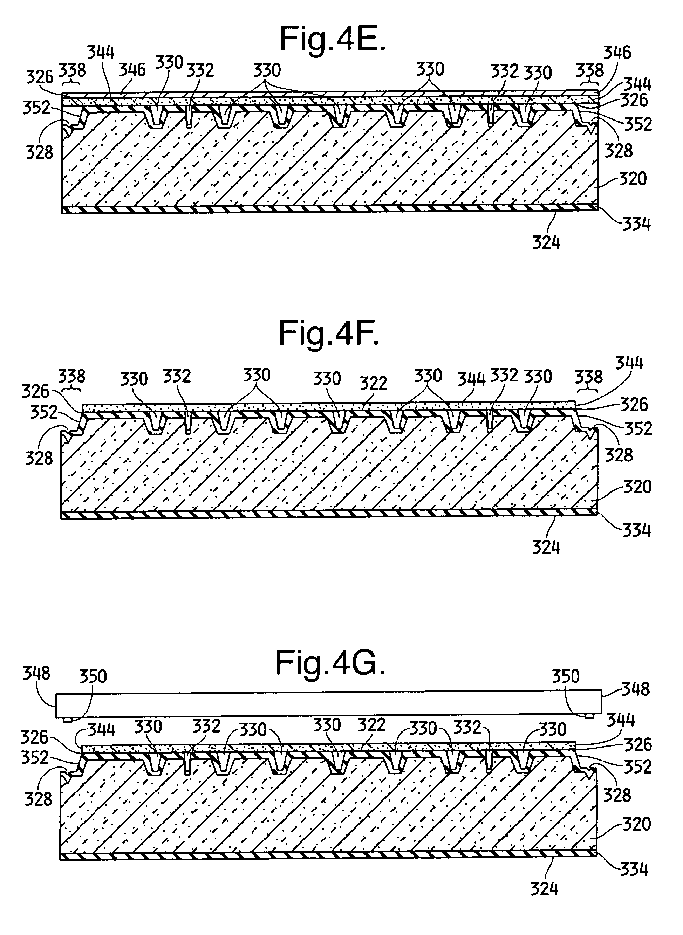

FIG. 4D illustrates that a second substrate 340 is bonded to the process side 322 of the first substrate 320. The second substrate 340 may include an etch stop layer 346 comprising, for example, a highly doped P layer, and an outer bond layer 344 comprising, for example, an epitaxial silicon layer or a single crystal layer. Note that unlike the process 100, the alignment features 328 located on the process side 322 of the first substrate 320 are buried or hidden by the overlying second substrate 340, and remain buried until the process operations illustrated in FIG. 4F.

FIG. 4E illustrates the first substrate 320 and the second substrate 340 after the second substrate 340 has been etched back to the etch stop layer 346 (if present). Specifically, the silicon 342 or other material of the second substrate 340 may be etched back with a potassium hydroxide or other etching solution. Alternatively, substrate 340 may be ground back to bond layer 344 using, for example, a mechanical grinding process.

FIG. 4F illustrates the first substrate 320 after the etch stop layer 346 (if present) has been etched away, or second substrate 340 has been ground back, leaving only the bond layer 344 of the second substrate 340 as the outermost layer of the process side 322 of the first substrate 320. The bond layer 344 is removed in a region 338 overlaying alignment features 328 by undercutting during the etching process. This is due to the exposure to the etching solution that the recesses 352 provide to the underside of the bond layer 344. As a result, the alignment features 328 are again accessibly exposed on the process side 322 of the first substrate 320.

FIG. 4G illustrates a mask 348 with alignment features 350 being aligned relative to the alignment features 328 of the first substrate 320 in order to pattern the bond layer 344 on the process side 322 of the first substrate 320. Specifically, aligning the alignment features 350 of the mask 348 with the alignment features 328 of the first substrate 320 ensures that the pattern applied to the bond layer 344 is properly aligned with recesses 330 and any other earlier defined features of the first substrate 320 that are buried or hidden under the bond layer 344.

Process steps subsequent to those illustrated in FIGS. 4A-4G may then be completed based on alignment to features that are patterned onto the bond layer 344 by the mask 348 in order to complete fabrication of the microchip devices, including semiconductor circuits or micro-machined devices, on the process side 322. Advantageously, the process 300 requires no upside down processing of the substrate 300 for back side alignment feature operations, only one manual projection alignment, and at most only one back side spin operation according to one embodiment. In addition, single side polished wafers can be utilized for substrates 320 and 340.

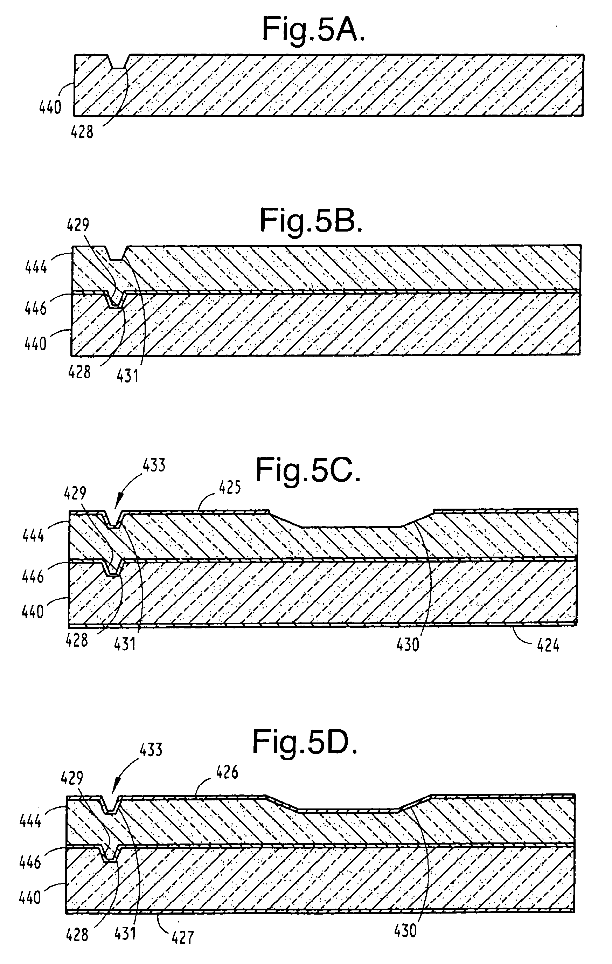

Referring to FIGS. 5A-5H, a process 400 for fabricating microchip devices is generally illustrated, according to another embodiment of the present invention. The process 400 includes several preliminary steps for the fabrication of microchip devices on a wafer, including, for example, microchip devices having a movable mechanical structure. Such microchip devices may comprise, for example, pressure sensors and/or accelerometers.

Referring to FIG. 5A, a first silicon wafer or substrate 440 having a pattern on or in its upper surface is provided, according to a first step of the process. The pattern in or on the upper surface of first silicon wafer 440 includes at least one alignment feature 428. As shown, alignment feature 428 is a cavity or depression in the upper surface of first silicon wafer 440. Alignment feature 428 is preferably formed by wet etching silicon wafer 440 through a patterned silicon dioxide mask. The depth of alignment feature 428 is optimally between 0.5µ and 1µ. In an alternative embodiment, the depth of alignment feature 428 is less than .5µ or greater than 1µ.

Referring to FIG. 5B, silicon wafer 440 is shown having an etch stop layer 446 deposited on its upper surface. As shown, etch stop layer 446 is composed of epitaxially grown silicon or silicon/germanium doped with boron to a level known to those familiar with the art as sufficient to behave as an etch stop for silicon etchants such as potassium hydroxide (KOH), ethyhlenediamene pyrocatecol (EDP), tetramethylammonium hydroxide (TMAH) or similar etchants. Silicon wafer 440 is also shown having an outer bond layer 444 deposited on top of etch stop layer 446. As shown, outer bond layer 444 is an n-type epitaxial silicon layer. Both etch stop layer 446 and outer bond layer 444 have alignment features (depressions 429 and 431, respectively) corresponding to alignment feature 428 on the upper surface of silicon wafer 440.

FIG. 5C shows silicon wafer 440 after a number of additional steps of the process 400 have been completed. In these steps, silicon wafer 440 has oxidation layer 424 grown on its lower surface and oxidation layer 425 grown on the top side of outer bond layer 444. Outer bond layer 444 and oxidation layer 425 includes an alignment feature 433 that is a depression corresponding to the alignment feature 431 on the upper surface of outer bond layer 444. After oxidation layer 425 has been grown on the upper surface of outer bond layer 444, a pattern is formed or located on the upper surface of oxidation layer 425. The pattern is located relative to alignment feature 433 such that when an etch is performed on oxidation layer 425, an opening in oxidation layer 425 will be formed at a specific location relative to alignment feature 433. Next, a wet etch is performed on the surface of outer bond layer 444 resulting in a cavity or recess 430 located in a specific position relative to alignment feature 433. In an alternative embodiment, cavity 430 is formed by dry etching outer bond layer 444.

FIG. 5D shows the resulting silicon wafer 440 after oxidation layers 425 and 424 have been removed, and new oxidation layers 426 and 427 have been formed on the lower surface of silicon wafer 440 and the upper surface of outer bond layer 444. Alignment feature 433 and recess 430 remain present in the surface of silicon wafer 440 after these steps, as shown in FIG. 5D.

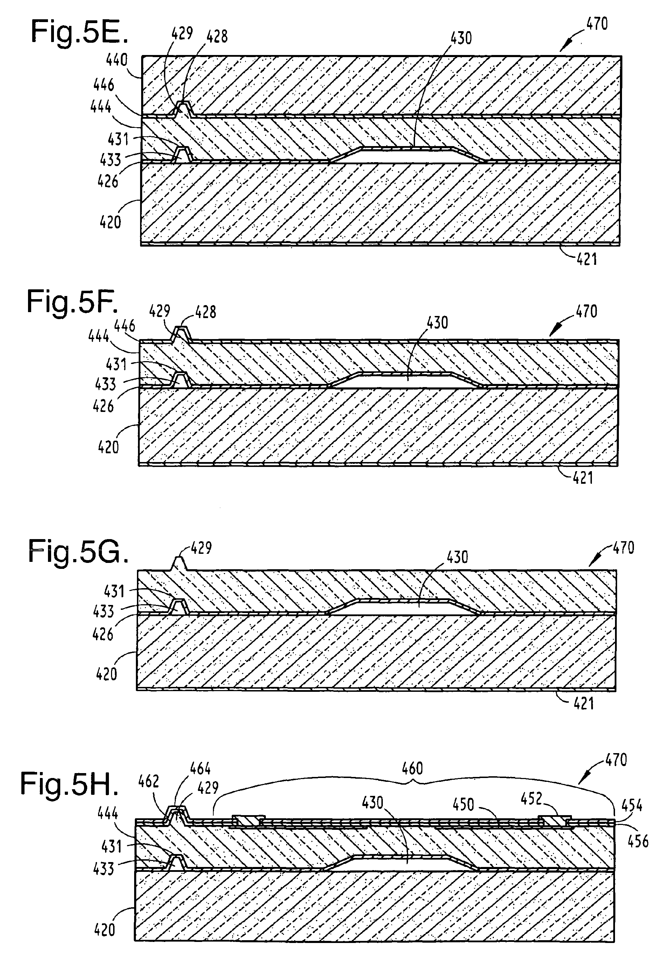

FIG. 5E shows a resulting structure 470 after silicon wafer 440, as shown in FIG. 5D, has been inverted, with oxidation layer 426 being bonded to the upper surface of a second silicon wafer 420. Silicon wafer 420 has layer 421 protecting its' backside. Layer 420 is composed of silicon dioxide or other material resistant to silicon etchants such as KOH, EDP, TMAH or similar etchants. FIG. 5E also shows that oxidation layer 427 has been removed from the lower surface (now upper surface) of silicon wafer 440.

Referring to FIG. 5F, the structure 470 is shown after silicon wafer 440 has been etched down to etch stop layer 446.

FIG. 5G shows the resulting structure 470 after etch stop layer 446 has been removed. As can be seen in FIG. 5G, structure 470 includes alignment features 433, 431, and 429. Alignment features 433, 431 and 429 may also be referred to as alignment discontinuities. Because these features are now inverted, they are hereinafter referred to as raised areas, rather than as depressions or cavities. Structure 470 also includes recess 430. It should be noted that alignment feature 433 and recess 430 also represent empty spaces, or gaps, formed between the surface of oxidation layer 426 and the upper surface of silicon wafer 420. It should also be noted that recess 430 is located at a specific location relative to alignment feature 433, and that because the location of alignment feature 433 corresponds to the location of alignment feature 431 and alignment feature 429, the alignment of additional structures relative to alignment feature 429 has the effect of aligning those structures to alignment features 431 and 433, as well as to recess 430.

Referring to FIG. 5H, the resulting structure 470 is shown after additional circuit features 450 and 452, and additional layers 454 and 456 have been aligned relative to recess 430 through the use of alignment feature 429. FIG. 5H also shows additional alignment features 462 and 464 resulting from additional processing layers 454 and 456 being deposited over alignment feature 429. Alignment features 462 and 464 may also be referred to as alignment discontinuities. It should be appreciated that still further processing layers could be added on top of alignment feature 464 and layer 454 such that features in those additional layers can be effectively aligned to alignment feature 433 and recess 430. As shown, recess 430, additional circuit structures 450 and 452, and layers 454 and 456 together form a completed microchip device 460. As shown, microchip device 460 is a MEMS pressure sensor. Alternatively, microchip device 460 is an accelerometer, gyroscope, or other MEMS (Micro-Electro-Mechanical Systems) device. In the present embodiment, first silicon wafer 440 and second silicon wafer 420 are shown being the same size, such that when first silicon wafer 440 and second silicon wafer 420 are bonded together, oxidation layer 426 and the upper surface of second silicon wafer 420 completely overlap. In an alternative embodiment, first silicon wafer 440 and second silicon wafer 420 are of different sizes such that they overlap by less than 100% but greater than 10%.

It should be appreciated that for each of the embodiments of the present invention described above, the substrate materials employed for the first and second substrates may include silicon wafers, or other substrate materials typically employed in the fabrication of microchip devices. In addition, it should be appreciated that materials used for coating the surfaces of the first and second substrates to form various layers, and for bonding the first and second substrates together, may include materials typically used in the fabrication of microchip devices. It should be appreciated that various coating methods known in the art may be used to apply coating materials used in the method. These include, but are not limited to, growing, deposition, patterning and masking, diffusion, and oxidation, among others. Furthermore, processes other than etching and grinding processes may be employed to remove various layers of material from the microchip devices, such as methods commonly employed in the fabrication of microchip devices. Tools such as lasers or other tools typically employed in the fabrication of microchip devices may also be employed to remove and shape the substrates and layers deposited on the substrates. Finally, although specific examples of the thickness of certain layers of the device were provided in the various embodiments (for example, the thickness of the dielectric layers), it should be appreciated that layers having a different thicknesses can be employed.

The embodiments of the microchip device fabrication method described above advantageously provide for unburied alignment features that can be conveniently formed, and that can be used to align process layers and features in circuit devices to earlier-formed layers and features without requiring specialized equipment capable of locating buried or hidden alignment features. The method enables the creation of microchip devices having features that are precisely aligned to earlier-formed hidden circuit structures through the use of unburied alignment features. The use of the method results in devices that have superior electro-mechanical characteristics relative to devices formed without the aid of the unburied alignment features.

It will be understood by those who practice the invention and those skilled in the art, that various modifications and improvements may be made to the invention without departing from the spirit of the disclosed concept. The scope of protection afforded is to be determined by the claims and by the breadth of interpretation allowed by law.

## Claims

1. A method of fabricating microchip devices, comprising the steps of:
forming a first alignment feature (128) in a first peripheral region (138) of a process side (122) of a first substrate (120);
overlaying a second substrate (140) on the process side (122) of the first substrate (120) such that the first alignment feature (128) remains exposed for subsequent process operations; and
bonding the second substrate (140) to the process side (122) of the first substrate (120).

2. The method of claim 1 further comprising the step of forming a second alignment feature (128) in a second peripheral region (138) of the process side (122) of a first substrate (120).

3. The method of claim 2, wherein the first and second peripheral regions (138) are located adjacent substantially opposite edges of the first substrate (120).

4. The method of claim 3 further comprising the step of selecting a second substrate (140) having a peripheral profile shaped to maintain exposure of the first and second alignment features (128) upon overlaying the second substrate (140) on the first substrate (120).

5. The method of claim 1, further comprising the step of removing a segment of the outer periphery of the second substrate (140), the segment corresponding to the first peripheral region (138) of the first substrate (120).

6. The method of claim 1 further comprising the step of aligning a subsequent process operation performed on the second substrate (140) to the first exposed alignment feature (128).

7. The method of claim 1 further comprising the step of forming recesses (130) in a device layer located on the process side (122) of the first substrate (120), the recesses (130) allowing for the deflection of a mechanical feature of the second substrate (140) toward the first substrate (120).

8. A method of fabricating microchip devices, comprising the steps of:
forming an alignment feature (328) on a process side (322) of a first substrate (320), the first substrate (320) having a device layer (326) on the process side (322) located in reference to the alignment feature (328);
bonding a second substrate (340) to the process side of the first substrate (320);
removing a portion of the second substrate (340), the portion overlaying the alignment feature (328); and
registering the alignment feature (328) to align a subsequent process operation on the second substrate (340) with the device layer (326) of the first substrate (320).

9. The method of claim 8, wherein the removing step includes resist masking and etching processes.

10. The method of claim 8 further comprising the step of locating a portion of the second substrate (340) that overlays the alignment feature (328) by reference to a peripheral feature of at least the first (320) and second (340) substrate.

11. The method of claim 8 further comprising the step of forming a recess (352) on the process side (322) of the first substrate (320) along a segment of the periphery of the first substrate (320) and locating the alignment feature (328) in the recess (352).

12. The method of claim 9 further comprising the step of forming recesses (330) in the device layer (326) of the first substrate (320) for deflection of a mechanical feature of the second substrate (340) toward the first substrate (320).

13. The method of claim 9, wherein the second substrate (340) includes one of an epitaxial layer and a single crystal layer on the side bonded to the first substrate (320).

14. A method of fabricating microchip devices, comprising the steps of:
providing an essentially planar first substrate (440) having a first upper surface and a second lower surface, and having as part of the first upper surface a first alignment feature (428);
depositing at least one layer of coating material (446) on the first upper surface of the first substrate (440), wherein the at least one layer of coating material (446) includes at least one alignment discontinuity (429) corresponding to the location of the first alignment feature (428), and wherein at least a portion of the at least one alignment discontinuity (429) is visible in the surface of the at least one layer of coating material (446);
bonding at least one of the at least one layer of coating material (446) and the first upper surface of the first substrate (440) to a first upper surface of a second substrate (420); and
forming at least one feature (452) on at least one of the second lower surface of the first substrate (440) and the at least one layer of coating material (454), wherein the position of the at least one feature (452) is determined by reference to an exposed alignment discontinuity (464) corresponding to one of the at least one alignment discontinuity (462) and the first alignment feature (428).

15. The method of claim 14, wherein the exposed alignment discontinuity (464) is located in at least one of the second lower surface of the first substrate (440) and the at least one layer of coating material (454).

16. The method of claim 14, further including the step of removing at least some coating material (446) from one of the second lower surface of the first substrate (440) and the at least one layer of coating material (446) prior to forming the at least one feature (452).

17. The method of claim 14, further including the step of removing at least one layer of coating material (446) from one of the second lower surface of the first substrate (440) and the at least one layer of coating material (446) prior to forming the at least one feature (452).

18. The method of claim 17, wherein the exposed alignment discontinuity is at least one of the at least one alignment discontinuity (464, 462, 431, 433) and the first alignment feature (428).

19. The method of claim 14, further including the step of forming a feature (430) in the at least one layer of coating material (444), wherein the position of the feature (430) is determined by reference to a visible portion of the at least one alignment discontinuity (433).

20. The method of claim 19, wherein the feature (430) is a recess extending into the at least one layer of coating material (444) from the first outer surface of the at least one coating material (444).

21. The method of claim 20, wherein the recess (430) provides a cavity into which mechanical features formed in at least one of the first substrate (440), second substrate (420), and the at least one layer of coating material (444) can deflect.

22. The method of claim 14, wherein the at least one layer of coating material (444) is an epitaxial layer.

23. A method of fabricating microchip devices, comprising the steps of:
providing an essentially planar first substrate (440) having a first upper surface and a second lower surface, and having as part of the first upper surface a first alignment feature (428);
bonding a second substrate (420) to the first upper surface of the first substrate (440) such that the second substrate and first substrate overlap to form a first structure (470); and
aligning a process operation performed on the first structure (470) to a visible feature on the surface of the first structure (470), wherein the visible feature is at least one of the first alignment feature (428) and a feature corresponding to the location of the first alignment feature (428).

24. The method of claim 23, wherein the bonded surfaces of the second substrate (420) and first substrate (440) overlap by at least 50%.
